# EUROPÄISCHE PATENTSCHRIFT

(11) **EP 3 552 310 B1**
(45) Veröffentlichungstag und Bekanntmachung des Hinweises auf die Patenterteilung: **30.12.2020**
(21) Anmeldenummer: 17804821.1
(22) Anmeldetag: 07.11.2017
(51) Int. Cl.: H03K 17/16, H03K 17/041, H03K 17/0414, H03K 17/0412, H03K 17/0422

(54) **STEUEREINRICHTUNG ZUM ANSTEUERN EINES BIPOLAREN SCHALTBAREN LEISTUNGSHALBLEITERBAUELEMENTS, HALBLEITERMODUL SOWIE VERFAHREN**
CONTROL DEVICE FOR ACTUATING A BIPOLAR SWITCHABLE POWER SEMICONDUCTOR DEVICE, SEMICONDUCTOR MODULE, AND METHOD
DISPOSITIF DE COMMANDE D'UN ÉLÉMENT SEMI-CONDUCTEUR DE PUISSANCE COMMUTABLE BIPOLAIRE, MODULE SEMI-CONDUCTEUR ET PROCÉDÉ

(30) Priorität: 18.01.2017 EP 17151987
(43) Veröffentlichungstag der Anmeldung: 16.10.2019
(73) Patentinhaber: Siemens Aktiengesellschaft, 80333 München (DE)
(72) Erfinder: BÖHMER, Jürgen, 90547 Stein (DE); KLEFFEL, Rüdiger, 91056 Erlangen (DE); KRAFFT, Eberhard Ulrich, 90419 Nürnberg (DE); NAGEL, Andreas, 90431 Nürnberg (DE); WEIGEL, Jan, 91077 Grossenbuch (DE)
(86) Internationale Anmeldenummer: PCT/EP2017/078420
(87) Internationale Veröffentlichungsnummer: WO 2018/133962

(56) Entgegenhaltungen:
- EP-A1- 2 632 048
- DE-A1- 3 905 645
- DE-A1- 3 905 645
- DE-A1- 10 206 392
- DE-A1- 10 206 392
- DE-A1-102015 220 594
- Mike - Mitchell: "Using PWM Timer_B as a DAC", Ti Application Report, 31. Dezember 2000 (2000-12-31), Seiten 1-21, XP055443341, Internet Gefunden im Internet: URL:http://www.ti.com/lit/an/slaa116/slaa1 16.pdf [gefunden am 2018-01-23]
- Mike - Mitchell: "Using PWM Timer_B as a DAC", Ti Application Report, 31 December 2000 (2000-12-31), pages 1-21, XP055443341, Internet Retrieved from the Internet: URL:http://www.ti.com/lit/an/slaa116/slaa1 16.pdf [retrieved on 2018-01-23]

## Beschreibung

Die vorliegende Erfindung betrifft eine Steuereinrichtung zum Ansteuern eines bipolaren schaltbaren Leistungshalbleiterbauelements, wobei die Steuereinrichtung dazu ausgelegt ist, eine elektrische Spannung an einem Gate-Anschluss des Leistungshalbleiterbauelements anzulegen und die elektrische Spannung zum Abschalten des Leistungshalbleiterbauelements von einem ersten Spannungswert auf einen zweiten Spannungswert zu reduzieren. Darüber hinaus betrifft die vorliegende Erfindung ein Halbleitermodul mit einer solchen Steuereinrichtung. Schließlich betrifft die vorliegende Erfindung ein Verfahren zum Ansteuern eines bipolaren schaltbaren Leistungshalbleiterbauelements.

Das Interesse richtet sich vorliegend auf bipolare schaltbare bzw. abschaltbare Leistungshalbleiterbauelemente. Ein solches bipolares schaltbares Leistungshalbleiterbauelement kann insbesondere ein IGBT sein. Beim Abschalten von bipolaren schaltbaren Leistungshalbleiterbauelementen werden die für den Stromfluss benötigen Ladungsträger ausgeräumt. Dabei entstehen beim Abschalten von konventionellen und rückwärtsleitfähigen IGBTs durch das Ausräumen der Ladungsträger hohe elektrische Feldstärken. Durch diese Feldstärkenbelastung kann das Leistungshalbleiterbauelement nicht beliebig schnell abgeschaltet werden. Des Weiteren ist die Anstiegsgeschwindigkeit der elektrischen Spannung an den Lastanschlüssen in erster Linie durch die Anforderungen der Last begrenzt. Sowohl die Ladungsträgerkonzentration in dem Leistungshalbleiterbauelement als auch die Schaltgeschwindigkeit beeinflussen die Ausschaltverluste des Leistungshalbleiterbauelements. Die Schaltgeschwindigkeit wird - begrenzt durch den einzuhaltenden sicheren Arbeitsbereich - zur Minimierung der Verluste so hoch wie möglich eingestellt. Üblicherweise erfolgt dies über eine geeignete Wahl der Höhe eines Gate-Entladestroms.

Das Gate des eingeschalteten Leistungshalbleiterbauelements ist auf eine elektrische Spannung mit einem ersten Spannungswert geladen. Beim Ausschalten des Leistungshalbleiterbauelements wird das Gate über einen Widerstand auf eine elektrische Spannung mit einem zweiten Spannungswert entladen. Die elektrische Spannung wird also von dem ersten Spannungswert auf den zweiten Spannungswert reduziert. Dabei bringt der Übergang von dem leitenden Zustand mit einer hohen Ladungsträgerkonzentration in den stromlosen Zustand vergleichsweise hohe Ausschaltverluste mit sich.

Es offenbart die DE 39 05 645 A1 ein Ansteuerverfahren zur Verbesserung des Überstromabschaltverhaltens von Leistungshalbleiterschaltern mit MOS-Steuereingang. Weiterhin offenbart die DE 102 06 392 A1 ein Verfahren und eine Vorrichtung zur Optimierung des Abschaltvorgangs eines nichteinrastenden, abschaltbaren Leistungs-Halbleiterschalters. Schließlich offenbart die DE 10 2015 220 594 A1 eine Halbleiter-Antriebseinheit und einen Stromrichter, der diese verwendet.

Es ist Aufgabe der vorliegenden Erfindung, eine Lösung aufzuzeigen, wie ein bipolares schaltbares Leistungshalbleiterbauelement der eingangs genannten Art effizienter ausgeschaltet werden kann.

Diese Aufgabe wird erfindungsgemäß durch eine Steuereinrichtung, durch ein Halbleitermodul sowie durch ein Verfahren mit den Merkmalen gemäß den jeweiligen unabhängigen Ansprüchen gelöst. Vorteilhafte Weiterbildungen der vorliegenden Erfindung sind Gegenstand der abhängigen Ansprüche.

Eine erfindungsgemäße Steuereinrichtung dient zum Ansteuern eines bipolaren schaltbaren Leistungshalbleiterbauelements. Dabei ist die Steuereinrichtung dazu ausgelegt, eine elektrische Spannung an einem Gate-Anschluss des Leistungshalbleiterbauelements anzulegen und die elektrische Spannung zum Abschalten des Leistungshalbleiterbauelements von einem ersten Spannungswert auf einen zweiten Spannungswert zu reduzieren. Ferner ist die Steuereinrichtung dazu ausgelegt, zum Abschalten des Leistungshalbleiterbauelements die elektrische Spannung von dem ersten Spannungswert zunächst auf einen Entsättigungswert zu reduzieren und anschließend die elektrische Spannung von dem Entsättigungswert auf den zweiten Spannungswert zu reduzieren, wobei der Entsättigungswert größer als eine Abschnürspannung des Leistungshalbleiterbauelements ist.

Mithilfe der Steuereinrichtung kann ein bipolares schaltbares bzw. abschaltbares Leistungshalbleiterbauelement angesteuert werden. Die Steuereinrichtung kann beispielweise Teil einer Ansteuerschaltung sein. Bei dem Leistungshalbleiterbauelement kann es sich insbesondere um einen Bipolartransistor mit isoliertem Gate-Anschluss (Insulated-Gate Bipolar Transistor, IGBT) handeln. Die Steuereinrichtung ist elektrisch mit der Gate-Elektrode bzw. dem Gate-Anschluss des Leistungshalbleiterbauelements verbunden. Dabei kann es vorgesehen sein, dass die Steuereinrichtung einen Gate-Widerstand aufweist, der mit dem Gate-Anschluss des Leistungshalbleiterbauelements verbunden ist. Mithilfe der Steuereinrichtung können elektrische Spannungen mit unterschiedlichen Spannungswerten bereitgestellt werden bzw. an dem Gate-Anschluss angelegt werden. Beispielweise kann die elektrische Spannung mit dem ersten Spannungswert an dem Gate-Anschluss angelegt werden, um das Leistungshalbleiterbauelement einzuschalten. Wenn die elektrische Spannung mit dem ersten Spannungswert an dem Gate-Anschluss anliegt, ist es insbesondere vorgesehen, dass eine Gate-Emitter-Spannung des Leistungshalbleiterbauelements über einen Schwellwert liegt. In diesem Fall befindet sich das Leistungshalbleiterbauelement im Durchlasszustand.. Wenn das Leistungshalbleiterbauelement abgeschaltet werden soll, wird die elektrische Spannung mittels der Steuereinrichtung von dem ersten Spannungswert auf den zweiten Spannungswert reduziert.

Gemäß einem wesentlichen Aspekt der vorliegenden Erfindung ist es vorgesehen, dass mittels der Steuereinrichtung die elektrische Spannung an dem Gate-Anschluss zunächst von dem ersten Spannungswert auf den Entsättigungswert reduziert wird und anschließend auf den zweiten Spannungswert reduziert wird. Zum Ausschalten des Leistungshalbleiterbauelements wird also die elektrische Spannung an dem Gate-Anschluss bzw. die Gate-Emitter-Spannung nicht unmittelbar auf den zweiten Spannungswert reduziert, sondern die elektrische Spannung wird zunächst auf den Entsättigungswert eingestellt. Dabei ist der Entsättigungswert kleiner als der erste Spannungswert und größer als der zweite Spannungswert. Mit anderen Worten kann kurz vor dem eigentlichen Abschaltvorgang ein Entsättigungspuls an dem Gate-Anschluss bereitgestellt werden. Dieser Entsättigungspuls entlädt das Gate bzw. den Gate-Anschluss des Leistungshalbleiterbauelements auf eine Spannung, welche leicht oberhalb der Abschnürspannung des Leistungshalbleiterbauelements liegt. Diese Abschnürspannung kann auch als Pinchoff-Spannung bezeichnet werden. Falls die Abschnürspannung an dem Leistungshalbleiterbauelement anliegt, ist ein Kanal des Leistungshalbleiterbauelements eingeschnürt. Dadurch, dass die elektrische Spannung an dem Gate-Anschluss zunächst auf den Entsättigungswert reduziert wird, kann die Ladungsträgerkonzentration innerhalb des Leistungshalbleiterbauelements reduziert werden. Somit muss beim Abschaltvorgang des Leistungshalbleiterbauelements weniger Ladung aus dem Leistungshalbleiterbauelement ausgeräumt werden. Damit können die Abschaltverluste beim Abschalten des Leistungshalbleiterbauelements reduziert werden und somit der Abschaltvorgang effizienter durchgeführt werden.

Die Steuereinrichtung weist einen ersten Schalter zum Anlegen der elektrischen Spannung mit dem ersten Spannungswert an dem Gate-Anschluss und einen zweiten Schalter zum Anlegen der elektrischen Spannung mit dem zweiten Spannungswert an dem Gate-Anschluss auf. Dabei können der erste Schalter und der zweite Schalter unabhängig voneinander angesteuert werden. Der erste Schalter dient dazu, den Gate-Anschluss mit der elektrischen Spannung mit dem ersten Spannungswert zu verbinden. In gleicher Weise dient der zweite Schalter dazu, den Gate-Anschluss mit der elektrischen Spannung mit dem zweiten Spannungswert zu verbinden. Mit den jeweiligen Schaltern kann beispielsweise eine elektrische Verbindung zwischen dem Gate-Anschluss sowie einer Spannungsquelle, welche die elektrische Spannung mit dem ersten Spannungswert bzw. dem zweiten Spannungswert bereitstellen, geschaltet werden. Es kann auch vorgesehen sein, dass der Gate-Anschluss mittels der Schalter mit einer Spannungssenke verbunden wird.

Die Steuereinrichtung ist dazu ausgelegt, den ersten Schalter und/oder den zweiten Schalter periodisch anzusteuern und die elektrische Spannung auf den Entsättigungswert durch Vorgeben eines Tastgrads der Ansteuerung des ersten Schalters und/oder des zweiten Schalters einzustellen. Mit anderen Worten kann die elektrische Spannung an dem Gate-Anschluss nach Art einer Pulsweitenmodulation bereitgestellt werden. Die Absenkung der Gate-Emitter-Spannung kann also durch eine Pulsweitenmodulation erreicht werden. Durch ein geeignetes Impuls-Pausen-Verhältnis wird am Gate-Anschluss des Leistungshalbleiterbauelements die Spannung auf den Entsättigungswert eingestellt. Dies ermöglicht eine zuverlässige Einstellung der elektrischen Spannung an den Gate-Anschluss.

Zudem weist die Steuereinrichtung eine Messeinheit zum Messen eines Kollektorstroms an einem Kollektor-Anschluss des Leistungshalbleiterbauelements auf und die Steuereinrichtung ist dazu ausgelegt, den Entsättigungswert anhand des Kollektorstroms zu bestimmen. Wie bereits beschrieben, kann der Entsättigungswert auf Grundlage der Abschnürspannung bzw. der Pinchoff-Spannung des Leistungshalbleiterbauelements bestimmt werden. Die Abschnürspannung kann anhand des Zusammenhangs des Kollektorstroms und der Gate-Emitter-Spannung ermittelt werden. Dabei ist es insbesondere vorgesehen, dass der Kollektorstrom vor dem Abschalten des Leistungshalbleiterbauelements gemessen wird und der Entsättigungswert bzw. die elektrische Spannung mit dem Entsättigungswert so bestimmt wird, dass diese sehr nahe an der Abschnürspannung liegt bzw. die Abschnürspannung minimal überschreitet. Damit kann der Entsättigungswert zuverlässig bestimmt werden.

Bevorzugt ist die Steuereinrichtung dazu ausgelegt, die elektrische Spannung mit dem Entsättigungswert für eine vorbestimmte Pulsdauer an dem Gate-Anschluss anzulegen. Insbesondere ist es vorgesehen, dass die elektrische Spannung mit dem Entsättigungswert so lange gehalten wird bzw. an dem Gate-Anschluss angelegt wird, bis die Ladungsträger in dem Leistungshalbleiterbauelement reduziert sind. Während die elektrische Spannung mit dem Entsättigungswert an dem Leistungshalbleiterbauelement angelegt wird, wird die Überschussladung durch den Laststrom unmittelbar ausgeräumt. Gleichzeitig rekombinieren die Ladungsträger, wobei dies deutlich langsamer geschieht. Währenddessen steigt auch die Durchlassspannung an. Dabei kann die Pulsdauer, während der die elektrische Spannung mit dem Entsättigungswert an dem Leistungshalbleiterbauelement angelegt wird, vorbestimmt sein. Die Pulsdauer kann beispielsweise auf Grundlage von zuvor durchgeführten Messungen bestimmt sein. Somit kann ein effizienter Abschaltvorgang erreicht werden.

Gemäß einer weiteren Ausgestaltung weist die Steuereinrichtung eine Messeinheit zum Messen einer Gate-Emitter-Spannung zwischen dem Gate-Anschluss und einem Emitter-Anschluss des Leistungshalbleiterbauelements während des Abschaltens auf und die Steuereinrichtung ist dazu ausgelegt, die Pulsdauer anhand der Gate-Emitter-Spannung zu bestimmen. Es kann also vorgesehen sein, dass die Gate-Emitter-Spannung während des Abschaltvorgangs fortlaufend gemessen wird. Die Gate-Emitter-Spannung beschreibt die elektrische Spannung, die mittels der Steuereinrichtung an dem Gate-Anschluss des Leistungshalbleiterbauelements angelegt wird. Somit kann die Ausgabe der Spannung mittels der Steuereinrichtung bzw. die Gate-Emitter-Spannung fortlaufend bestimmt werden und folglich die Pulsdauer präzise eingestellt werden.

In einer nicht beanspruchten Ausführungsform ist die Steuerrichtung dazu ausgelegt, zum Abschalten des Leistungshalbleiterbauelements den ersten Schalter zu öffnen, danach den zweiten Schalter für eine erste Zeitdauer zu schließen, danach den zweiten Schalter für eine zweite Zeitdauer zu öffnen und anschließend den zweiten Schalter zu schließen. Beispielsweise kann der erste Schalter zu einem ersten Zeitpunkt geschlossen werden und gleichzeitig kann der zweite Schalter geöffnet werden. Nach der ersten Zeitdauer kann der zweite Schalter wieder geöffnet werden. Dabei bleibt der zweite Schalter für die zweite Zeitdauer geöffnet. Hierbei sind die erste Zeitdauer und die zweite Zeitdauer so gewählt, dass sich insgesamt der Entsättigungswert für die Spannung an dem Gate-Anschluss ergibt. Die Summe der ersten Zeitdauer und der zweiten Zeitdauer entspricht insbesondere der Pulsdauer. Dabei stellt die zweite Zeitdauer einer hochohmigen Ansteuerung bzw. einer Umschaltung auf einen hochohmigen Gate-Widerstand dar. Nach dem Entsättigungspuls kann dann der zweite Schalter zu einem zweiten Zeitpunkt wieder geöffnet werden, um das Gate vollständig zu entladen. Somit kann mithilfe des ersten und des zweiten Schalters die elektrische Spannung an dem Gate-Anschluss gesteuert werden.

Gemäß einer nicht beanspruchten Ausführungsform weist die Steuereinrichtung einen dritten Schalter zum Anlegen der elektrischen Spannung mit dem Entsättigungswert auf, und die Steuereinrichtung ist dazu ausgelegt, zu einem ersten Zeitpunkt den ersten Schalter zu öffnen und den dritten Schalter zu schließen sowie zu einem zweiten Zeitpunkt den dritten Schalter zu öffnen und den zweiten Schalter zu schließen. Wenn sich das Leistungshalbleiterbauelement in den Durchlasszustand befindet, ist der erste Schalter geschlossen. Zum Abschalten des Leistungshalbleiterbauelements wird zu dem ersten Zeitpunkt der erste Schalter geöffnet und gleichzeitig der dritte Schalter geschlossen. Somit liegt die elektrische Spannung mit dem Entsättigungswert an dem Gate-Anschluss an. Nach Absenkung der Ladungsträger im Halbleiterbauelement wird zu einem zweiten Zeitpunkt der dritte Schalter geöffnet und der zweite Schalter geschlossen. Somit liegt die elektrische Spannung mit dem zweiten Spannungswert an dem Gate-Anschluss an. Somit kann das Leistungshalbleiterbauelement mit verminderten Schaltverlusten ausgeschaltet werden.

In einer weiteren Ausführungsform weist die Steuereinrichtung einen analogen Verstärker zum Bereitstellen der elektrischen Spannung mit dem ersten Spannungswert, dem Entsättigungswert und dem zweiten Spannungswert auf. Der analoge Verstärker kann als analoge Verstärkerendstufe ausgebildet sein, mittels welcher die elektrische Spannung am Gate-Anschluss kontinuierlich eingestellt werden kann. Mit einer solchen Art von Endstufe lassen sich theoretisch weitreichende optimierte Gate-Spannungstrajektorien einstellen. Somit kann auch eine Regelung der Strom-und/oder Spannungstransienten des zu steuernden Leistungshalbleiterbauelements ermöglicht werden.

Ein erfindungsgemäßes Halbleitermodul umfasst ein bipolares schaltbares Leistungshalbleiterbauelement und eine erfindungsgemäße Steuereinrichtung. Dabei dient die erfindungsgemäße Steuereinrichtung zum Ansteuern des bipolaren schaltbaren Leistungshalbleiterbauelements. Bei dem Leistungshalbleiterbauelement kann es sich insbesondere um einen Bipolartransistor mit isolierter Gate-Elektrode bzw. mit isoliertem Gate-Anschluss handeln. Das Leistungshalbleiterbauelement kann also als IGBT ausgebildet sein. Das Halbleitermodul kann beispielsweise ein Umrichter sein. Dabei ist es insbesondere vorgesehen, dass die Pulsdauer, während der die elektrische Spannung mit dem Entsättigungswert an dem Leistungshalbleiterbauelement eingelegt wird, im Steuersatz des Umrichters berücksichtigt wird, da diese als zusätzliche Ausschaltverzögerung wirkt.

Ein erfindungsgemäßes Verfahren dient zum Ansteuern eines bipolaren schaltbaren Leistungshalbleiterbauelements. Hierbei wird mittels einer Steuereinrichtung eine elektrische Spannung an einem Gate-Anschluss des Leistungshalbleiterbauelements angelegt und die elektrische Spannung wird zum Abschalten des Leistungshalbleiterbauelements von einem ersten Spannungswert auf einen zweiten Spannungswert reduziert. Dabei ist es vorgesehen, dass die elektrische Spannung zum Abschalten des Leistungshalbleiterbauelements von dem ersten Spannungswert zunächst auf einen Entsättigungswert reduziert wird und die elektrische Spannung anschließend von dem Entsättigungswert auf den zweiten Spannungswert reduziert wird, wobei der Entsättigungswert größer als eine Abschnürspannung des Leistungshalbleiterbauelements ist.

Die mit Bezug auf die erfindungsgemäße Steuereinrichtung beschriebenen Vorteile und Weiterbildungen gelten sinngemäß für das erfindungsgemäße Halbleitermodul sowie das erfindungsgemäße Verfahren.

Die vorliegende Erfindung wird nun anhand von bevorzugten Ausführungsbeispielen sowie unter Bezugnahme auf die beigefügten Zeichnungen näher erläutert. Dabei zeigen:
- FIG 1: einen zeitlichen Verlauf einer elektrischen Spannung an einem Gate-Anschluss vor einem Gateentladewiderstand eines Leistungshalbleiterbauelements beim Abschalten des Leistungshalbleiterbauelements gemäß dem Stand der Technik;
- FIG 2: den zeitlichen Verlauf der elektrischen Spannung an den Gate-Anschluss des Leistungshalbleiterbauelement beim Abschalten des Leistungshalbleiterbauelements gemäß einer Ausführungsform der Erfindung;
- FIG 3: einen Verlauf einer Abschnürspannung sowie eines Entsättigungswerts der elektrischen Spannung;
- FIG 4: ein Halbleitermodul, welches eine Steuereinrichtung und ein Leistungshalbleiterbauelement umfasst, gemäß einer ersten Ausführungsform;
- FIG 5: Schaltverläufe von Schaltern der Steuereinrichtung gemäß FIG 4 in Abhängigkeit von der Zeit;
- FIG 6: ein Halbleitermodul mit einer Steuereinrichtung gemäß einer weiteren Ausführungsform;
- FIG 7: Schaltverläufe der Schalter der Steuereinrichtung gemäß FIG 6 in einer ersten Ausführungsform;
- FIG 8: Schaltverläufe der Schalter der Steuereinrichtung gemäß FIG 6 in einer zweiten Ausführungsform; und
- FIG 9: ein Halbleitermodul mit einer Steuereinrichtung gemäß einer weiteren Ausführungsform.

In den Figuren werden gleiche und funktionsgleiche Elemente mit den gleichen Bezugszeichen versehen.

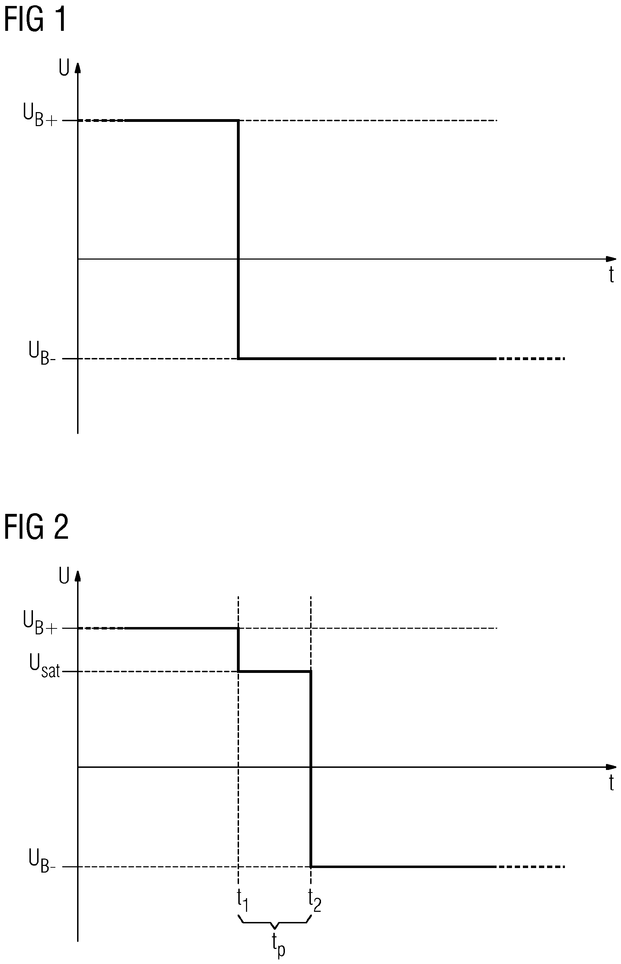

FIG 1 zeigt einen Verlauf einer elektrischen Spannung U in Abhängigkeit von der Zeit t, welche während eines Ausschaltens eines Leistungshalbleiterbauelements 1 an einem Gate-Anschluss des Leistungshalbleiterbauelements 1 angelegt wird. Die elektrische Spannung U beschreibt die Spannung vor einem möglichen Gateentladewiderstand, welcher üblicherweise zwischen dem Gate-Anschluss des Leistungshalbleiterbauelements 1 und der Steuereinrichtung 2 angeordnet ist. Dabei beschreibt der Verlauf der Spannung U, welche in FIG 1 gezeigt ist, einen Abschaltvorgang gemäß dem Stand der Technik. Falls das Leistungshalbleiterbauelement 1 eingeschaltet ist, liegt an dem Gate-Anschluss eine elektrische Spannung U mit einem ersten Spannungswert U_{B+} an. Der erste Spannungswert U_{B+} kann eine positive elektrische Spannung sein. Beim Abschalten des Leistungshalbleiterbauelements 1 wird die elektrische Spannung U von dem ersten Spannungswert U_{B+} auf einen zweiten Spannungswert U_{B-} reduziert. Der zweite Spannungswert U_{B-} kann beispielsweise einer negativen elektrischen Spannung zugeordnet sein. Dabei bringt der direkte Übergang von dem leitenden Zustand mit hoher Ladungsträgerkonzentration in den stromlosen Zustand vergleichsweise hohe Abschaltverluste mit sich.

Im Vergleich hierzu zeigt FIG 2 den Verlauf der elektrischen Spannung U in Abhängigkeit von der Zeit t bei einem Abschaltvorgang gemäß einer Ausführungsform der Erfindung. Hierbei wird die elektrische Spannung U an dem Gate-Anschluss von dem ersten Spannungswert U_{B+} zunächst auf einen Entsättigungswert Uₛₐₜ und anschließend auf den zweiten Spannungswert U_{B-} reduziert. Dabei liegt die elektrische Spannung U mit dem Entsättigungswert Uₛₐₜ für eine vorbestimmte Pulsdauer tₚ an dem Gate-Anschluss an. Die Pulsdauer tₚ beginnt an einem ersten Zeitpunkt t1 und endet an einem zweiten Zeitpunkt t2. Dadurch, dass die elektrische Spannung U an dem Gate-Anschluss zunächst auf den Entsättigungswert Uₛₐₜ reduziert wird, kann vor dem eigentlichen Abschaltvorgang des Leistungshalbleiterbauelements 1 die Ladungsträgerkonzentration reduziert werden. Dadurch muss beim Abschaltvorgang weniger Ladung aus dem Leistungshalbleiterbauelement 1 ausgeräumt werden. Folglich gehen die Abschaltverluste zurück.

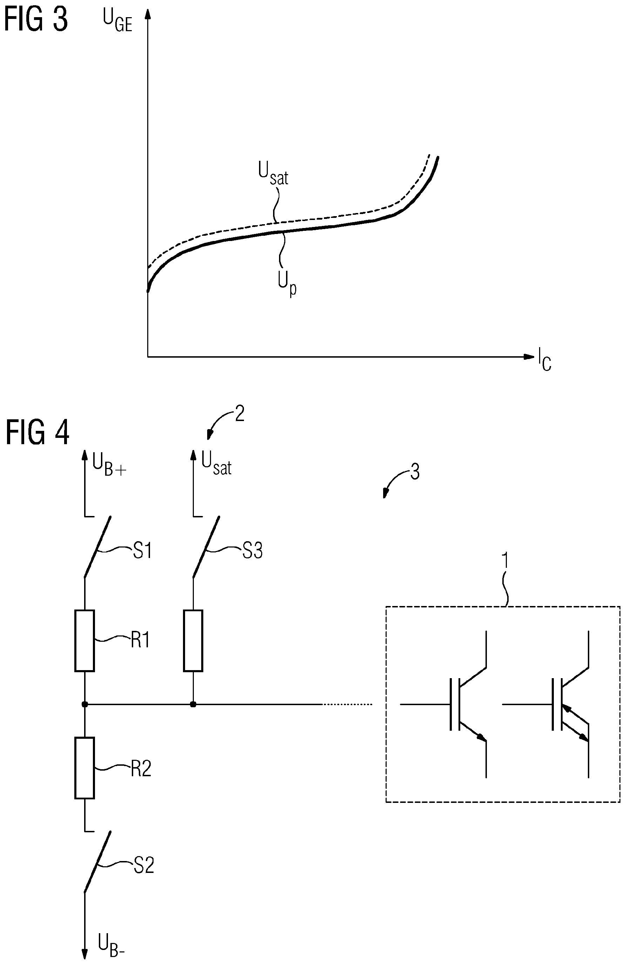

Dabei ist der Entsättigungswert Uₛₐₜ so bestimmt, dass dieser leicht oberhalb einer laststromabhängigen Abschnürspannung U_{P} des Leistungshalbleiterbauelements 1 liegt. Diese Abschnürspannung U_{P} kann auch als Pinchoff-Spannung bezeichnet werden. FIG 3 zeigt einen Verlauf der Abschnürspannung U_{P} sowie den Verlauf des Entsättigungswerts Uₛₐₜ. Dabei zeigt das Diagramm in FIG 3 die Gate-Emitter-Spannung U_{GE} in Abhängigkeit von dem Kollektorstrom I_{C}. Dabei kann der Entsättigungswert Uₛₐₜ eine festgelegte Höhe aufweisen, welche mindestens der maximal zu erwartenden Abschnürspannung U_{P} entspricht. Der Entsättigungswert Uₛₐₜ kann auch durch die Messung des Kollektorstroms I_{C} vor dem Abschalten sehr nahe an der Abschnürspannung U_{P} eingestellt werden. Dies setzt allerdings eine einstellbare Spannungsquelle bzw. Spannungssenke voraus.

FIG 4 zeigt ein Halbleitermodul 3 gemäß einer ersten Ausführungsform. Das Halbleitermodul 3 umfasst eine Steuereinrichtung 2 sowie das Leistungshalbleiterbauelement 1. Das Leistungshalbleiterbauelement 1 kann als konventioneller oder rückwärtsleitfähiger IGBT ausgebildet sein. Vorliegend ist beispielhaft ein Ersatzschaltbild des rückwärtsleitfähigen IGBTs für das Leistungshalbleiterbauelement 1 gezeigt. In diesem Ausführungsbeispiel umfasst die Steuereinrichtung 2 einen ersten Schalter S1, über welchen unter Zwischenschaltung eines ersten Widerstands R1 das Leistungshalbleiterbauelement 1 mit einer elektrischen Spannung U mit dem ersten Spannungswert U_{B+} verbunden werden kann. Des Weiteren umfasst die Steuereinrichtung 2 einen zweiten Schalter S2, über welchen das Leistungshalbleiterbauelement 1 unter Zwischenschaltung eines zweiten Widerstands R2 mit einer elektrischen Spannung U mit dem zweiten Spannungswert U_{B-} verbunden werden kann. Zudem umfasst die Steuereinrichtung 2 einen dritten Schalter S3, über welchen das Leistungshalbleiterbauelement 1 unter Zwischenschaltung eines dritten Widerstands R3 mit einer elektrischen Spannung U mit dem Entsättigungswert Uₛₐₜ verbunden werden kann.

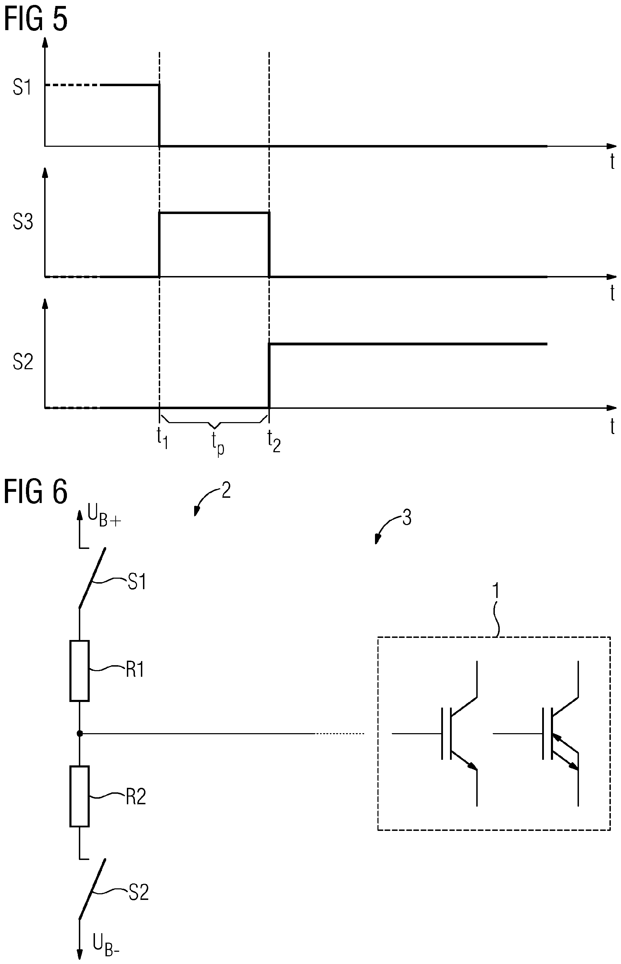

FIG 5 zeigt die Schaltverläufe der Schalter S1, S2 und S3 der Steuereinrichtung 2 gemäß FIG 4 in Abhängigkeit von der Zeit t. Zum Abschalten des Leistungshalbleiterbauelements 1 wird der erste Schalter S1 zu dem ersten Zeitpunkt t1 geöffnet. Gleichzeitig wird der dritte Schalter S3 geschlossen. Somit kann der Entsättigungspuls für die Pulsdauer tₚ eingeleitet werden. Nach Absenkung der Ladungsträger in dem Leistungshalbleiterbauelement 1 wird über alleinige Aktivierung des zweiten Schalters S2 zu dem zweiten Zeitpunkt t2 das Leistungshalbleiterbauelement 1 mit verminderter Ladungsträgerkonzentration und somit verminderten Schaltverlusten ausgeschaltet.

FIG 6 zeigt ein Halbleitermodul 3 gemäß einer weiteren Ausführungsform. Hierbei umfasst die Steuereinrichtung 2 nur den ersten Schalter S1 und den zweiten Schalter S2, welche im Zusammenhang mit der Schalteinrichtung 2 gemäß FIG 4 beschrieben wurden. Hierbei wird das weitere Spannungsniveau des Entsättigungswerts Uₛₐₜ nicht benötigt. Wie nachfolgend erläutert, kann die Absenkung der Gate-Emitter-Spannung U_{GE} durch kurzzeitiges, nicht vollständiges, Entladen des Gates erfolgen.

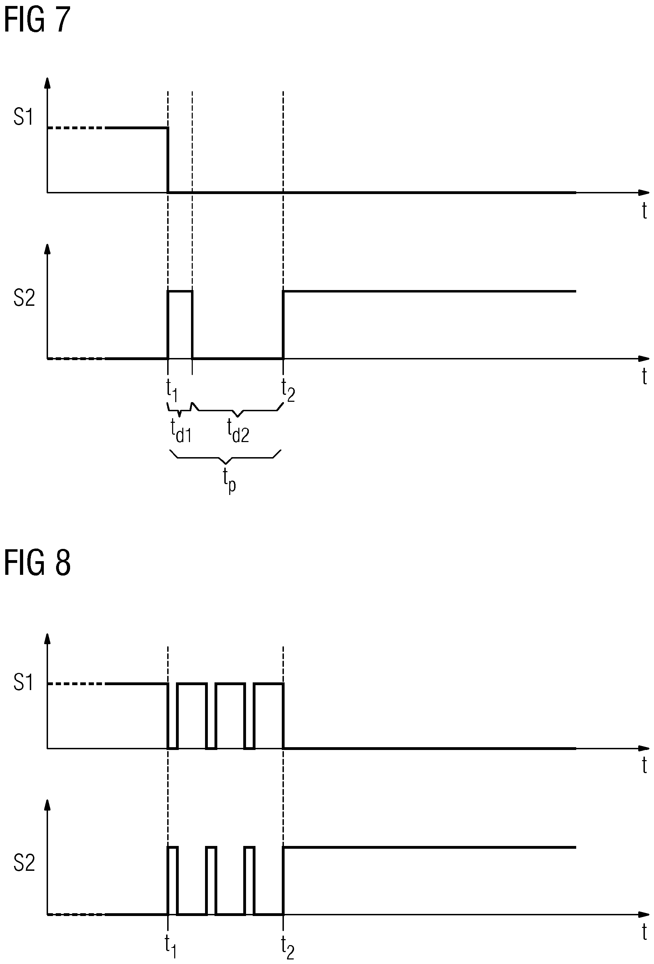

FIG 7 zeigt die Schaltverläufe der Schalter S1 und S2 der Steuereinrichtung 2 gemäß FIG 6 in Abhängigkeit von der Zeit t gemäß einer ersten Ausführungsform. Dabei wird die Spannung U an dem Gate durch das Deaktivieren des ersten Schalters S1 und kurzzeitiges Aktivieren des zweiten Schalters S2 auf den Entsättigungswert Uₛₐₜ gebracht. Zu dem ersten Zeitpunkt t1 wird der erste Schalter S1 geöffnet und der zweite Schalter S2 für die erste Zeitdauer t_{d1} geschlossen. Die erste Zeitdauer t_{d1} kann entweder fest vorgegeben sein oder durch Messung der Gate-Emitter-Spannung bestimmt werden. Weiterhin wäre es möglich, hierzu eine damit verbundene Anhebung der Kollektor-Emitter-Spannung zu erfassen. Nach Erreichen des Entsättigungswerts Uₛₐₜ werden sowohl der erste Schalter S1 als auch der zweite Schalter S2 für die zweite Zeitdauer t_{d2} deaktiviert und somit die Ansteuerung hochohmig geschaltet. Alternativ kann auch durch die Umschaltung auf einen hochohmigen Gate-Widerstand ein kleinerer Gate-Strom eingestellt werden. Nach dem Entsättigungswert Uₛₐₜ, der für die Pulsdauer tₚ anliegt, wird der ab Schaltvorgang zum zweiten Zeitpunkt t2 mit Aktivieren des zweiten Schalters S2 fortgeführt.

FIG 8 zeigt die Schaltverläufe der Schalter S1 und S2 der Steuereinrichtung 2 gemäß FIG 6 in Abhängigkeit von der Zeit t gemäß einer zweiten Ausführungsform. Hierbei wird die Gate-Emitter-Spannung U_{GE} durch eine Pulsweitenmodulation erreicht. Durch ein geeignetes Impuls-Pausen-Verhältnis wird am Gate-Anschluss des Leistungshalbleiterbauelements 1 der Entsättigungswert Uₛₐₜ eingestellt. Bevor das Gate des Leistungshalbleiterbauelements 1 mit dem zweiten Schalter S2 auf den zweiten Spannungswert U_{B-} entladen wird, wird mit einer Pulsweitenmodulation der Entsättigungspuls durch Ansteuerung des ersten Schalters S1 und des zweiten Schalters S2 eingeleitet. Dabei wird der Entsättigungswert Uₛₐₜ mit dem entsprechenden Tastverhältnis des ersten Schalters S1 und des zweiten Schalters S2 eingestellt.

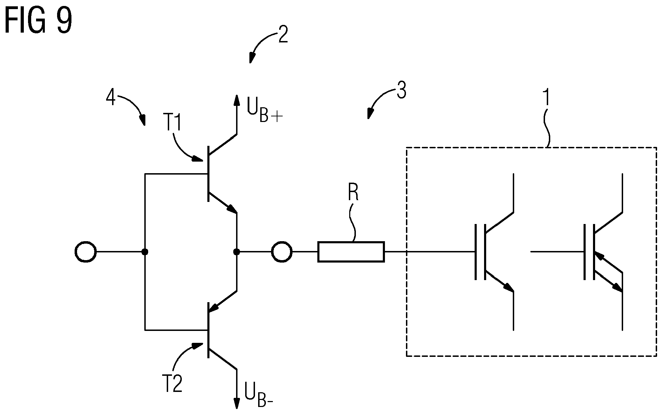

FIG 9 zeigt ein Halbleitermodul 3 gemäß einer weiteren Ausführungsform. Hierbei umfasst die Steuereinrichtung 2 einen analogen Verstärker 4 bzw. eine analoge Verstärkerendstufe. Der Verstärker 4 umfasst einen ersten Transistor T1, über welchen die elektrische Spannung U mit dem ersten Spannungswert U_{B+} unter Zwischenschaltung des Widerstands R an dem Leistungshalbleiterbauelement angelegt werden kann. Zudem umfasst der Verstärker 4 einen zweiten Transistor T2, über welchen die elektrische Spannung U mit dem zweiten Spannungswert U_{B-} an dem Leistungshalbleiterbauelement 1 angelegt werden kann. Mithilfe des Verstärkers 4 kann die elektrische Spannung U kontinuierlich eingestellt werden. Somit kann der Verlauf der elektrischen Spannung U, welcher im Zusammenhang mit FIG 2 erläutert wurde, an dem Gate-Anschluss des Leistungshalbleiterbauelements 1 angelegt werden.

Durch die Verwendung der Steuereinrichtung 2 bzw. durch das Ausschaltverhalten kann die Feldstärkebelastung des Leistungshalbleiterbauelements 1 beim Ausschalten reduziert werden, da über den Entsättigungswert Uₛₐₜ die Ladungsträgerkonzentration im Leistungshalbleiterbauelement 1 gesenkt wird. Bei Ausnutzung der Robustheitsgrenzen bzw. des sicheren Arbeitsbereichs, welche insbesondere höhere Schaltgeschwindigkeiten durch einen höheren Gate-Entladestrom ohne Überschreitung der Feldstärkegrenzen beschreiben, lassen sich Schaltverluste deutlich reduzieren. Insbesondere lässt sich dies ausnutzen, wenn die Anstiegsgeschwindigkeit der Spannung an den Hauptanschlüssen des Leistungshalbleiterbauelements 1 durch die Applikationen nicht begrenzt wird. Die beschriebenen Halbleitermodule 3 können insbesondere Teil eines Umrichters sein. Somit kann durch die Reduktion der Schaltverluste der Wirkungsgrad des Umrichters gesteigert werden.

## Patentansprüche

1. Steuereinrichtung (2) zum Ansteuern eines bipolaren schaltbaren Leistungshalbleiterbauelements (1), wobei die Steuereinrichtung (2) dazu ausgelegt ist, eine elektrische Spannung (U) an einem Gate-Anschluss des Leistungshalbleiterbauelements (1) anzulegen und die elektrische Spannung (U) zum Abschalten des Leistungshalbleiterbauelements (U) von einem ersten Spannungswert (U_{B+}) auf einen zweiten Spannungswert (U_{B-}) zu reduzieren, wobei die Steuereinrichtung (2) dazu ausgelegt ist, zum Abschalten des Leistungshalbleiterbauelements (1), die elektrische Spannung (U) von dem ersten Spannungswert (U_{B+}) zunächst auf einen Entsättigungswert (Uₛₐₜ) zu reduzieren und anschließend die elektrische Spannung (U) von dem Entsättigungswert (Uₛₐₜ) auf den zweiten Spannungswert (U_{B-}) zu reduzieren, wobei der Entsättigungswert (Uₛₐₜ) größer als eine Abschnürspannung (U_{P}) des Leistungshalbleiterbauelements (1) ist, wobei die Steuereinrichtung (2) einen ersten Schalter (S1) zum Anlegen der elektrischen Spannung (U) mit dem ersten Spannungswert (U_{B+}) an dem Gate-Anschluss und einen zweiten Schalter (S2) zum Anlegen der elektrischen Spannung (U) mit dem zweiten Spannungswert (U_{B-}) an dem Gate-Anschluss aufweist, **dadurch gekennzeichnet, dass** die Steuereinrichtung (2) dazu ausgelegt ist, den ersten Schalter (S1) und/oder den zweiten Schalter (S2) periodisch anzusteuern und die elektrische Spannung (U) auf den Entsättigungswert (Uₛₐₜ) durch Vorgeben eines Tastgrads der Ansteuerung des ersten Schalters (S1) und/oder des zweiten Schalters (S2) einzustellen, die Steuereinrichtung (2) eine Messeinheit zum Messen eines Kollektorstroms (I_{C}) an einem Kollektor-Anschluss des Leistungshalbleiterbauelements (2) aufweist und die Steuereinrichtung (2) dazu ausgelegt ist, den Entsättigungswert (Uₛₐₜ) anhand des Kollektorstroms (I_{C}) zu bestimmen.

2. Steuereinrichtung (2) nach Anspruch 1, wobei die Steuereinrichtung (2) dazu ausgelegt ist, die elektrische Spannung (U) mit dem Entsättigungswert (Uₛₐₜ) für eine bestimmte Pulsdauer (tₚ) an dem Gate-Anschluss anzulegen.

3. Steuereinrichtung (2) nach Anspruch 2, wobei die Steuereinrichtung (2) eine Messeinheit zum Messen einer Gate-Emitter-Spannung (U_{GE}) zwischen dem Gate-Anschluss und einem Emitter-Anschluss des Leistungshalbleiterbauelements (1) während des Abschaltens aufweist und die Steuereinrichtung (2) dazu aufgelegt ist, die Pulsdauer (t_{d}) anhand der Gate-Emitter-Spannung (U_{GE}) zu bestimmen.

4. Halbleitermodul (3) mit einem eines bipolaren schaltbaren Leistungshalbleiterbauelement (1) und mit einer Steuereinrichtung (2) nach einem der vorhergehenden Ansprüche zum Ansteuern des bipolaren schaltbaren Leistungshalbleiterbauelements (1).

5. Halbleitermodul (3) nach Anspruch 4, wobei das bipolare schaltbare Leistungshalbleiterbauelement (1) ein Bipolartransistor mit isoliertem Gate-Anschluss ist.

6. Verfahren zum Ansteuern eines bipolaren schaltbaren Leistungshalbleiterbauelements (1), bei welchem mittels einer Steuereinrichtung (2), eine elektrische Spannung (U) an einem Gate-Anschluss des Leistungshalbleiterbauelements (1) angelegt wird und die elektrische Spannung (U) zum Abschalten des Leistungshalbleiterbauelements (U) von einem ersten Spannungswert (U_{B+}) auf einen zweiten Spannungswert (U_{B-}) reduziert wird, wobei die elektrische Spannung (U) zum Abschalten des Leistungshalbleiterbauelements (1) von dem ersten Spannungswert (U_{B+}) zunächst auf einen Entsättigungswert (Uₛₐₜ) reduziert wird und die elektrische Spannung (U) anschließend von dem Entsättigungswert (Uₛₐₜ) auf den zweiten Spannungswert (U_{B-}) reduziert wird, wobei der Entsättigungswert (Uₛₐₜ) größer als eine Abschnürspannung (U_{P}) des Leistungshalbleiterbauelements (1) ist, wobei die Steuereinrichtung (2) einen ersten Schalter (S1) zum Anlegen der elektrischen Spannung (U) mit dem ersten Spannungswert (U_{B+}) an dem Gate-Anschluss und einen zweiten Schalter (S2) zum Anlegen der elektrischen Spannung (U) mit dem zweiten Spannungswert (U_{B-}) an dem Gate-Anschluss aufweist, **dadurch gekennzeichnet, dass** der erste Schalter (S1) und/oder der zweite Schalter (S2) periodisch angesteuert werden und die elektrische Spannung (U) auf den Entsättigungswert (Uₛₐₜ) durch Vorgeben eines Tastgrads der Ansteuerung des ersten Schalters (S1) und/oder des zweiten Schalters (S2) eingestellt wird und mittels einer Messeinheit der Steuereinrichtung (2) ein Kollektorstrom (I_{C}) an einem Kollektor-Anschluss des Leistungshalbleiterbauelements (2) gemessen wird und der Entsättigungswert (Uₛₐₜ) mittels der die Steuereinrichtung (2) anhand des Kollektorstroms (I_{C}) bestimmt wird.

## Claims

1. Control device (2) for driving a bipolar switchable power semiconductor component (1), wherein the control device (2) is designed to apply an electrical voltage (U) to a gate terminal of the power semiconductor component (1) and, in order to turn off the power semiconductor component (U), to reduce the electrical voltage (U) from a first voltage value (U_{B+}) to a second voltage value (U_{B-}), wherein the control device (2) is designed, in order to turn off the power semiconductor component (1), firstly to reduce the electrical voltage (U) from the first voltage value (U_{B+}) to a desaturation value (Uₛₐₜ) and then to reduce the electrical voltage (U) from the desaturation value (Uₛₐₜ) to the second voltage value (U_{B-}) , the desaturation value (Uₛₐₜ) being greater than a pinch-off voltage (U_{P}) of the power semiconductor component (1), wherein the control device (2) has a first switch (S1) for applying the electrical voltage (U) with the first voltage value (U_{B+}) to the gate terminal and a second switch (S2) for applying the electrical voltage (U) with the second voltage value (U_{B-}) to the gate terminal, **characterized in that** the control device (2) is designed to activate the first switch (S1) and/or the second switch (S2) periodically and to set the electrical voltage (U) to the desaturation value (Uₛₐₜ) by specifying a duty cycle for the activation of the first switch (S1) and/or of the second switch (S2), the control device (2) has a measuring unit for measuring a collector current (I_{C}) at a collector terminal of the power semiconductor component (2) and the control device (2) is designed to determine the desaturation value (Uₛₐₜ) on the basis of the collector current (I_{C}).

2. Control device (2) according to Claim 1, wherein the control device (2) is designed to apply the electrical voltage (U) with the desaturation value (Uₛₐₜ) to the gate terminal for a specific pulse duration (t_{P}).

3. Control device (2) according to Claim 2, wherein the control device (2) has a measuring unit for measuring a gate-emitter voltage (U_{GE}) between the gate terminal and an emitter terminal of the power semiconductor component (1) during the turn-off process, and the control device (2) is designed to determine the pulse duration (t_{d}) on the basis of the gate-emitter voltage (U_{GE}).

4. Semiconductor module (3) with a bipolar switchable power semiconductor component (1) and with a control device (2) according to any one of the preceding claims for driving the bipolar switchable power semiconductor component (1).

5. Semiconductor module (3) according to Claim 4, wherein the bipolar switchable power semiconductor component (1) is a bipolar transistor with insulated gate terminal.

6. Method for driving a bipolar switchable power semiconductor component (1), in which by means of a control device (2), an electrical voltage (U) is applied to a gate terminal of the power semiconductor component (1) and, in order to turn off the power semiconductor component (U), the electrical voltage (U) is reduced from a first voltage value (U_{B+}) to a second voltage value (U_{B-}) , wherein, in order to turn off the power semiconductor component (1), the electrical voltage (U) is firstly reduced from the first voltage value (U_{B+}) to a desaturation value (Uₛₐₜ) and the electrical voltage (U) is then reduced from the desaturation value (Uₛₐₜ) to the second voltage value (U_{B-}), the desaturation value (Uₛₐₜ) being greater than a pinch-off voltage (U_{P}) of the power semiconductor component (1), wherein the control device (2) has a first switch (S1) for applying the electrical voltage (U) with the first voltage value (U_{B+}) to the gate terminal and a second switch (S2) for applying the electrical voltage (U) with the second voltage value (U_{B-}) to the gate terminal, **characterized in that** the first switch (S1) and/or the second switch (S2) are periodically activated and the electrical voltage (U) is set to the desaturation value (Uₛₐₜ) by specifying a duty cycle for the activation of the first switch (S1) and/or of the second switch (S2), and by means of a measuring unit of the control device (2) a collector current (I_{C}) is measured at a collector terminal of the power semiconductor component (2) and the desaturation value (Uₛₐₜ) is determined by means of the control device (2) on the basis of the collector current (I_{C}).

## Revendications

1. Dispositif (2) de commande pour commander un composant (1) à semi-conducteur de puissance commutable bipolaire, le dispositif (2) de commande étant conçu pour appliquer une tension (U) électrique à une borne de grille du composant (1) à semi-conducteur de puissance et pour réduire la tension (U) électrique, afin de bloquer le composant (U) à semi-conducteur de puissance, d'une première valeur (U_{B+}) de tension à une deuxième valeur (U_{B-}) de tension, le dispositif (2) de commande étant conçu, afin de bloquer le composant (1) à semi-conducteur de puissance, pour réduire la tension (U) électrique de la première valeur (U_{B+}) de tension d'abord à une valeur (Uₛₐₜ) de désaturation et ensuite pour réduire la tension (U) électrique de la valeur (Uₛₐₜ) de désaturation à la deuxième valeur (U_{B-}) de tension, la valeur (Uₛₐₜ) de désaturation étant plus grande qu'une tension (Uₚ) de blocage du composant (1) à semi-conducteur de puissance, le dispositif (2) de commande ayant un premier interrupteur (S1) pour l'application de la tension (U) électrique ayant la première valeur (U_{B+}) de tension à la borne de grille et un deuxième interrupteur (S2) pour l'application de la tension (U) électrique ayant la deuxième valeur (U_{B-}) de tension à la borne de grille, **caractérisé en ce que** le dispositif (2) de commande est conçu pour commander le premier interrupteur (S1) et/ou le deuxième interrupteur (S2) périodiquement et pour régler la tension (U) électrique à la valeur (Uₛₐₜ) de désaturation par prescription d'un degré d'échantillonnage de la commande du premier interrupteur (S1) et/ou du deuxième interrupteur (S2), le dispositif (2) de commande ayant une unité de mesure pour la mesure d'un courant (I_{c}) de collecteur à une borne de collecteur du composant (2) à semi-conducteur de puissance et le dispositif (2) de commande étant conçu pour déterminer la valeur (Uₛₐₜ) de désaturation à l'aide du courant (I_{c}) de collecteur.

2. Dispositif (2) de commande suivant la revendication 1, dans lequel le dispositif (2) de commande est conçu pour appliquer à la borne de grille la tension (U) électrique ayant la valeur (Uₛₐₜ) de désaturation pendant une durée (tₚ) d'impulsion déterminée.

3. Dispositif (2) de commande suivant la revendication 2, dans lequel le dispositif (2) de commande a une unité de mesure pour la mesure d'une tension (U_{GE}) de grille-émetteur entre la borne de grille et une borne d'émetteur du composant (1) à semi-conducteur de puissance pendant le blocage et le dispositif (2) de commande est conçu pour déterminer la durée (t_{d}) d'impulsion à l'aide de la tension (U_{GE}) de grille-émetteur.

4. Module (3) à semi-conducteur, comprenant un composant (1) à semi-conducteur de puissance commutable bipolaire et comprenant un dispositif (2) de commande suivant l'une des revendications précédentes pour commander le composant (1) à semi-conducteur commutable bipolaire.

5. Module (3) à semi-conducteur suivant la revendication 4, dans lequel le composant (1) à semi-conducteur de puissance commutable bipolaire est un transistor bipolaire à borne de grille isolée.

6. Procédé de commande d'un composant (1) à semi-conducteur de puissance commutable bipolaire, dans lequel, au moyen d'un dispositif (2) de commande, on applique une tension (U) électrique à une borne de grille du composant (1) à semi-conducteur de puissance et on réduit la tension (U) électrique, pour le blocage du composant (1) à semi-conducteur de puissance, d'une première valeur (U_{B+}) de tension à une deuxième valeur (U_{B-}) de tension, la tension (U) électrique étant, pour le blocage du composant (1) à semi-conducteur de puissance, réduite de la première valeur (U_{B+}) de tension d'abord à une valeur (Uₛₐₜ) de désaturation et la tension (U) électrique étant ensuite réduite de la valeur (Uₛₐₜ) de désaturation à la deuxième valeur (U_{B-}) de tension, la valeur (Uₛₐₜ) de désaturation étant plus grande qu'une tension (Uₚ) de blocage du composant (1) à semi-conducteur de puissance, le dispositif (2) de commande ayant un premier interrupteur (S1) pour appliquer la tension (U) électrique ayant la première valeur (U_{B+}) de tension à la borne de grille et un deuxième interrupteur (S2) pour appliquer la tension (U) électrique ayant la deuxième valeur (U_{B-}) de tension à la borne de grille, **caractérisé en ce que** l'on commande périodiquement le premier interrupteur (S1) et/ou le deuxième interrupteur (S2) et on règle la tension (U) électrique à la valeur (Uₛₐₜ) de désaturation en prescrivant un degré d'échantillonnage de la commande du premier interrupteur (S1) et/ou du deuxième interrupteur (S2) et, au moyen d'une unité de mesure du dispositif (2) de commande, on mesure un courant (I_{c}) de collecteur à une borne de collecteur du composant (2) à semi-conducteur de puissance et on détermine la valeur (Uₛₐₜ) de désaturation au moyen du dispositif (2) de commande à l'aide du courant (I_{c}) de collecteur.
